# NEUE EUROPÄISCHE PATENTSCHRIFT

(11) **EP 0 920 714 B2**
(45) Veröffentlichungstag und Bekanntmachung des Hinweises auf die Entscheidung über den Einspruch: **04.11.2009**
(45) Hinweis auf die Patenterteilung: 06.05.2004
(21) Anmeldenummer: 98916916.4
(22) Anmeldetag: 11.03.1998
(51) Int. Cl.: H01R 9/26, H01R 13/506

(54) **ELEKTRISCHES ODER ELEKTRONISCHES GERÄT**
ELECTRICAL OR ELECTRONIC APPARATUS
APPAREIL ELECTRIQUE OU ELECTRONIQUE

(30) Priorität: 16.03.1997 DE 19710768
(43) Veröffentlichungstag der Anmeldung: 09.06.1999
(73) Patentinhaber: PHOENIX CONTACT GmbH & Co. KG, 32825 Blomberg (DE)
(72) Erfinder: FEYE-HOHMANN, Jürgen, D-32756 Detmold (DE); FOLLMANN, Hartmut, D-32699 Extertal (DE); REIBKE, Heinz, D-32105 Bad Salzuflen (DE)
(74) Vertreter: Gesthuysen, Hans Dieter
(86) Internationale Anmeldenummer: PCT/EP1998/001396
(87) Internationale Veröffentlichungsnummer: WO 1998/042045

(56) Entgegenhaltungen:
- EP-A- 0 236 711
- EP-A- 0 680 114
- DE- - 3 922 551
- DE-A- 4 327 172
- DE-A- 4 402 002
- US- - 3 891 295
- US- - 4 228 483
- US- - 4 516 189
- US-A- 4 472 764
- US-A- 5 593 325

## Beschreibung

Die Erfindung betrifft ein elektrisches oder elektronisches Gerät zum Aufsetzen auf eine Tragschiene, mit einem Gehäuse, mit wenigstens einer im Gehäuse angeordneten Leiterplatte und mit in Längsrichtung der Tragschiene weisenden Kontakten für eine Daten- und/oder Energiebusverbindung mit benachbarten, auf die Tragschiene aufgesetzten und korrespondierende Kontakte aufweisenden Geräten, wobei das Gehäuse mindestens zweiteilig ausgebildet ist und ein die Leiterplatte aufnehmendes Oberteil und ein die Kontakte aufweisendes Sockelteil vorgesehen sind und wobei das Oberteil mit dem Sockelteil über eine erste Verriegelung und das Sockelteil mit der Tragschiene über eine zweite Verriegelung lösbar verbindbar sind.

Ein elektrisches oder elektronisches Gerät mit einem einteiligen Gehäuse ist aus der DE 44 02 002 A1 bekannt. Bei dem bekannten Elektronikgerät ist es so, daß dieses auf eine handelsübliche Tragschiene aufrastbar ist und beim Aufrasten automatisch mit benachbarten Elektronikgeräten durchkontaktiert wird. Auf diese Weise ergibt sich über die durchkontaktierten Elektronikgeräte eine Busverbindung.

Probleme ergeben sich bei dieser bekannten Konstruktion in dem Fall, wenn die Leiterplatte in dem elektrischen oder elektronischen Gerät defekt ist und das elektrische oder elektronische Gerät zur Reparatur oder Austauschzwecken aus dem Verbund herausgenommen werden muß. Dies führt automatisch zu einer Unterbrechung der Daten- und/oder Energiebusverbindung.

Ein elektrisches oder elektronisches Gerät der eingangs genannten Art ist aus der US 4,472,764 bekannt. Dieses bekannte Gerät bietet aufgrund der Teilbarkeit des Gehäuses grundsätzlich die Möglichkeit, die Leiterplatte zusammen mit dem die Leiterplatte aufnehmenden Oberteil des Gehäuses zu entnehmen, ohne daß die über die Sockelteile realisierte Busverbindung unterbrochen wird oder die an den Anschlüssen des Gehäuses angeschlossenen externen Leitungen entfernt werden müssen. Nachteilig bei dem bekannten Gerät ist, daß es auch aufgrund der Mehrteiligkeit des Geräts - das Gehäuse besteht nicht nur aus einem Oberteil und einem Sockelteil, sondern das Sockelteil ist ebenfalls zweiteilig ausgebildet und nur über einen separaten Befestigungsfuß mit der Tragschiene verbunden - zu einer unbeabsichtigten Unterbrechung der Daten- und/oder Energiebusverbindung kommen kann, wenn das Oberteil vom Sockelteil abgezogen wird und es dabei auch zu einem Lösen des Sockelteils von der Tragschiene kommt oder wenn der Monteur zum Abnehmen des Oberteils unbeabsichtigterweise das Sockelteil löst.

Aufgabe der vorliegenden Erfindung ist es, ein elektrisches oder elektronisches Gerät der eingangs genannten Art zur Verfügung zu stellen, bei dem ein unbeabsichtigtes Lösen des Sockelteils von der Tragschiene sicher ausgeschlossen werden kann.

Die zuvor hergeleitete und aufgezeigte Aufgabe ist erfindungsgemäß durch ein elektrisches oder elektronisches gerät mit den Merkmalen des Anspruchs 1 gelöst. Durch die erfindungsgemäße Ausgestaltung ist nun sichergestellt, daß die zweite Verriegelung keinesfalls vor der ersten Verriegelung gelöst werden kann, da das Oberteil zunächst abgenommen werden muß, um die zweite Verriegelung überhaupt entriegeln zu können. Eine unbeabsichtigte Unterbrechung der Busverbindung ist damit ausgeschlossen.

Bevorzugt sind die erste und zweite Verriegelung jeweils als Rastverbindung ausgeführt, da sich eine derartige Verriegelung schnell und einfach realisieren läßt. Bei einer vorteilhaften Ausführungsform ist am Oberteil ein federnder Rastarm vorgesehen, während am Sockelteil zum Rastarm korrespondierende Rasthaken vorgesehen sind.

Erfindungsgemäß ist weiterhin vorgesehen; daß das Oberteil auf das Sockelteil aufschwenkbar ist, wobei die erste Verriegelung einen von der Außenseite des Gehäuses manuell zu betätigenden Griff- oder Eingriffsabschnitt am Rastarm zum Lösen des Oberteils vom Sockelteil aufweist. Das Lösen des Oberteils vom Sockelteil kann bei dieser Ausführungsform extrem einfach durch Lösen nur einer Rastverbindung realisiert werden. Über den Griff- oder Eingriffsabschnitt kann der Rastarm manuell per Hand oder mit Hilfe eines Werkzeugs, beispielsweise eines Schraubendrehers, geöffnet werden.

Damit beim Lösen bzw. Entriegeln des Oberteils vom Sockelteil das Sockelteil nicht mit gelöst wird, was im schlimmsten Falle eine Unterbrechung der Daten- und/oder Energiebusverbindung bedeuten würde, ist eine zweite rastbare Verriegelung zur lösbaren Verbindung des Sockelteils mit der Tragschiene vorgesehen. Wichtig ist hierbei, daß die zweite Verriegelung völlig unabhängig von der ersten Verriegelung ist, so daß ein Lösen der ersten Verriegelung nicht unbeabsichtigterweise zu einem Lösen auch der zweiten Verriegelung führen kann.

Um einerseits das Sockelteil in einfacher Weise mit der Tragschiene verbinden zu können und um andererseits ein unbeabsichtigtes Lösen des Sockelteils von der Tragschiene zu verhindern, ist weiterhin vorgesehen, daß das Sockelteil auf die Tragschiene aufschwenkbar ist und die zweite Verriegelung einen federbelasteten Riegel am Sockelteil zum einseitigen Verriegeln der Tragschiene aufweist.

Der Riegel ist dabei im Bereich der Unterseite des Sockelteils angeordnet und damit von außen her an sich nicht zugänglich. Zum Öffnen der zweiten Verriegelung ist am Riegel eine Betätigungsöffnung und auf der Oberseite des Sockelteils eine Einführöffnung für ein Werkzeug, beispielsweise einen Schraubendreher, vorgesehen, wobei die Betätigungsöffnung derart versetzt zur Einführöffnung angeordnet ist, daß beim Einführen des Werkzeugs in die Betätigungs- und Einführöffnung der Riegel entgegen der Federbelastung bewegt und das Sockelteil freigegeben wird. Die Einführöffnung am Sockelteil ist nur bei abgenommenem Oberteil zugänglich ist.

Damit die Leiterplatte im Gehäuse richtig angeordnet ist, d. h. in jedem Falle korrekt in einer am Sockelteil vorgegebenen Leiterplattenaufnahme mit den dort vorgesehenen Kontakten kontaktiert und damit außerdem sichergestellt ist, daß die Leiterplatte beim Abnehmen des Oberteils vom Sockelteil mit abgezogen wird, ist erfindungsgemäß außerdem vorgesehen, daß in der Leiterplatte und im Oberteil jeweils korrespondierende Öffnungen zum Einstecken wenigstens einer Fixiereinrichtung von der Außenseite des Gehäuses vorgesehen sind. Zur Erzielung einer guten Verbindung reicht es dabei aus, die Fixiereinrichtung lediglich in die Leiterplatte einzustecken. Die Fixierung erfolgt vorliegend also ausschließlich durch das Einstecken der Fixiereinrichtung von außen her in die Öffnungen im Oberteil und der Leiterplatte. Dieses Einstecken ist nur dann möglich, wenn die jeweiligen Öffnungen im Oberteil und der Leiterplatte ausgefluchtet sind. Bei ausgefluchteten Öffnungen befindet sich die Leiterplatte dann in der gewünschten Einbau- und Kontaktierungsposition.

Um eine sichere Verbindung der Leiterplatte zum Gehäuse zu erzielen, weist die Fixiereinrichtung wenigstens einen, vorzugsweise jedoch zwei Einsteckschenkel auf, wobei am Einsteckschenkel wenigstens eine Verdickung vorgesehen ist, über die sich ein guter Reibschluß mit der korrespondierenden Öffnung in der Leiterplatte erzielen läßt.

Neben der Fixierungsfunktion kann die Fixiereinrichtung aber auch einen weiteren Zweck erfüllen, nämlich zum elektrischen Anschluß dienen. Häufig müssen nämlich an der Leiterplatte Zuführungskontakte befestigt werden. Dies kann ohne weiteres bei entsprechender Ausbildung über die Fixiereinrichtung erfolgen. Zu diesem Zweck sollte die Fixiereinrichtung wenigstens ein Klemmenelement in Form einer Anschlußklemme aufweisen. In diesem Falle kontaktiert der Einsteckschenkel mit einer Leiterbahn auf der Leiterplatte. Das elektrische oder elektronische Gerät hat dann auch die Funktion einer anreihbaren Klemme.

Damit die Fixiereinrichtung nicht über das elektrische oder elektronische Gerät seitlich übersteht, ist bei einer vorteilhaften Ausführungsform vorgesehen, daß die Fixiereinrichtung in einer korrespondierenden Aufnahme im Oberteil aufgenommen ist. Wenn bei dieser Ausführungsform die Fixiereinrichtung wenigstens ein Klemmenelement aufweist, also zum Anschluß von Zuführungskontakten dient, ist im Oberteil wenigstens eine Anschlußöffnung zum Einführen des Zuführungskontaktes in das Klemmenelement und wenigstens eine Betätigungsöffnung zur Betätigung des Klemmenelementes vorgesehen.

Damit die Fixiereinrichtung während des Gebrauchs des Klemmenelemtens keinen mechanischen Beanspruchungen unterliegt, die sich auf die Leiterplatte übertragen könnten, weist die Fixiereinrichtung einen aus dem Klemmenelement herausragenden Schenkel auf, von dem der Einsteckschenkel absteht. An dem Schenkel ist nun eine Stufe vorgesehen, während sich in der Aufnahme ein korrespondierender stufenförmiger Schlitz befindet, in dem die Stufe des Schenkels am Gehäuse anliegt. Eine etwaige Zug- oder Druckbelastung wird somit vom Gehäuse aufgenommen und nicht auf die Leiterplatte übertragen.

Damit die Fixiereinrichtung nicht aus dem elektrischen oder elektronischen Gerät herausfallen kann, ist schließlich eine Abdeckung für die Aufnahme vorgesehen, die lösbar mit dem Gehäuse verbindbar, vorzugsweise verrastbar ist.

Weitere Merkmale, Vorteile und Anwendungsmöglichkeiten der vorliegenden Erfindung ergeben sich aus der nachfolgenden Beschreibung von Ausführungsbeispielen anhand der Zeichnung und der Zeichnung selbst.

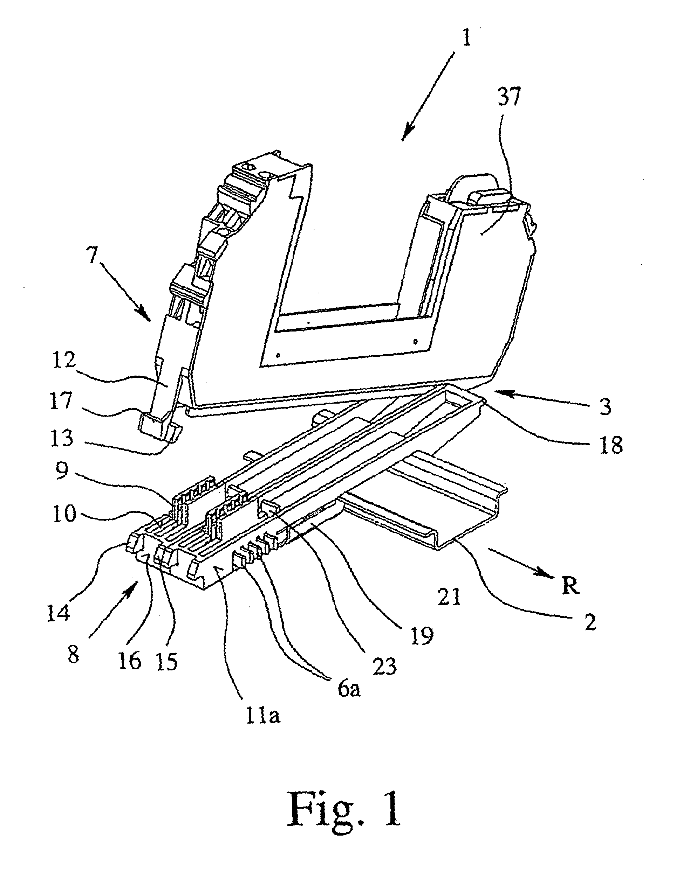

Es zeigt
- Fig. 1: eine perspektivische Ansicht eines auf eine Tragschiene aufgesetzten erfindungsgemäßen elektrischen oder elektronischen Gerätes,

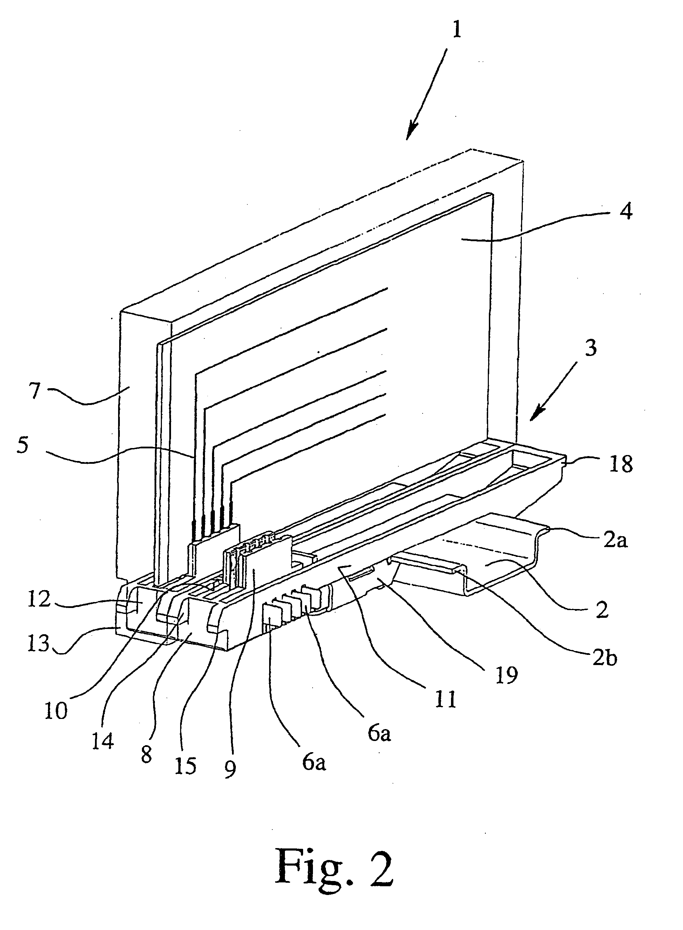

- Fig. 2: eine perspektivische Ansicht einer anderen Ausführungsform eines erfindungsgemäßen elektrischen oder elektronischen Gerätes,
- Fig. 3: eine perspektivische Ansicht von Sockelteilen von erfindungsgemäßen elektrischen oder elektronischen Geräten,
- Fig. 4: eine andere perspektivische Ansicht von Sockelteilen von erfindungsgemäßen elektrischen oder elektronischen Geräten,
- Fig. 5: eine Vorderansicht im Schnitt eines Teils eines erfindungsgemäßen elektrischen oder elektronischen Gerätes,
- Fig. 6: eine Vorderansicht im Schnitt einer anderen Ausführungsform eines erfindungsgemäßen elektrischen oder elektronischen Gerätes,
- Fig. 7: eine perspektivische Ansicht der Art der Fixierung der Leiterplatte eines erfindungsgemäßen elektrischen oder elektronischen Gerätes unter Weglassung des Gehäuses,
- Fig. 8: eine perspektivische Ansicht von zwei Fixiereinrichtungen zur Fixierung der Leiterplatte und
- Fig. 9: eine perspektivische Ansicht eines Teils des Gehäuses eines erfindungsgemäßen elektrischen oder elektronischen Gerätes.

In den Figuren ist ein elektrisches oder elektronisches Gerät 1 dargestellt, das zum Aufsetzen auf eine als Hutschiene ausgebildete Tragschiene 2 vorgesehen ist. Das elektrische oder elektronische Gerät 1 selbst weist ein Gehäuse 3 auf, das aus einem isolierenden Material, insbesondere Kunststoff, besteht. Im Gehäuse 3 befindet sich eine Leiterplatte 4. Die Leiterplatte 4 ist in an sich bekannter Weise mit Leiterbahnen 5 auf beiden Leiterplattenseiten und mit nicht näher dargestellten elektronischen Bauteilen versehen. Des weiteren weist das elektrische oder elektronische Gerät 1 in Tragschienenrichtung R weisende als Messerkontakte ausgebildete Kontakte 6a auf der einen Seite 11a und korrespondierende, als Kontaktaufnahmen ausgebildete Kontakte 6b auf der anderen Seite 11b für eine Daten- und/oder Energiebusverbindung zur Kontaktierung von benachbarten, auf die Tragschiene 2 aufgesetzten und korrespondierende Kontakte aufweisenden weiteren Elektronikgeräten auf. Elektrische oder elektronische Geräte 1 der zuvor beschriebenen Art können aufgrund ihrer Ausbildung auf einer Tragschiene 2 aneinandergereiht werden, wobei sich über die jeweiligen Kontakte 6a, 6b eine Daten- und/oder Energiebusverbindung ergibt. Das dargestellte elektrische oder elektronische Gerät 1 ist außerdem in Art einer anreihbaren Klemme ausgebildet und insbesondere für den Ex-Schutzbereich geeignet.

Wesentlich ist nun, daß das Gehäuse 3 zumindest zweiteilig ausgebildet ist. Im dargestellten Ausführungsbeispiel weist das Gehäuse 3 ein die Leiterplatte 4 aufnehmendes Oberteil 7 und ein die Kontakte 6a, 6b aufweisendes Sockelteil 8 auf. Zur Kontaktierung mit der Leiterplatte 4 weist das Sockelteil 8 eine Leiterplattenaufnahme 9 auf, die über die Oberseite 10 des Sockelteils 8 übersteht. Die Kontakte in der Leiterplattenaufnahme 9 korrespondieren mit den Kontakten 6a, 6b in den Seiten 11a, 11b des Sockelteils 8.

Zur lösbaren Verbindung des Oberteils 7 mit dem Sockelteil 8 ist eine erste Verriegelung vorgesehen, die als Rastverbindung ausgebildet ist. Hierzu weist die erste Verriegelung einen federnden Rastarm 12 auf, der am Oberteil 7 vorgesehen ist. Der Rastarm 12, der nach unten hin über das Oberteil 7 übersteht, weist einen Rastabschnitt 13 auf, der mit zwei korrespondierenden Rasthaken 14, 15, die an der Stirnseite 16 des Sockelteils 8 vorgesehen sind, zusammenwirken. Die Rasthaken 14, 15 sowie der Rastabschnitt 13 weisen jeweils Auflaufschrägen auf, um das Aufrasten zu erleichtern. Die beiden Rasthaken 14, 15 sind voneinander beabstandet, so daß der Rastarm im verrasteten Zustand zwischen den Rasthaken 14, 15 liegt. Zum Öffnen der Rastverbindung der ersten Verriegelung ist am Ende des Rastarms 12 ein Eingriffsabschnitt in Form einer Tasche 17 vorgesehen, in die ein Werkzeug, wie beispielsweise ein Schraubendreher, eingesetzt und mit dessen Hilfe der Rastarm 12 ausgefedert werden kann. Während an der einen Stirnseite des Gehäuses 3 die Rastverbindung vorgesehen ist, befindet sich an der anderen Stirnseite am Oberteil 7 ein nicht dargestellter Aufnahmeschlitz für einen korrespondierenden Vorsprung 18 am Sockelteil 8, so daß das Oberteil 7 auf das Sockelteil 8 aufschwenkbar ist.

Zur lösbaren Verbindung des Sockelteils 8 mit der Tragschiene 2 ist eine zweite Verriegelung vorgesehen. Wie das Oberteil 7 auf das Sockelteil 8 so ist auch das Sockelteil 8 auf die Tragschiene 2 aufschwenkbar. Zu diesem Zweck ist an der Unterseite 20 des Sockelteils 8 ein nicht näher dargestellter Schlitz zum Eingriff des korrespondierenden Vorsprungs 2a der Tragschiene 2 vorgesehen. Gegenüberliegend zu der Schwenkverbindung befindet sich am Sockelteil 8 ein federbelasteter Riegel 19, der zum einseitigen Untergreifen der Tragschiene 2 bzw. des korrespondierenden Vorsprungs 2b der Tragschiene 2 dient.

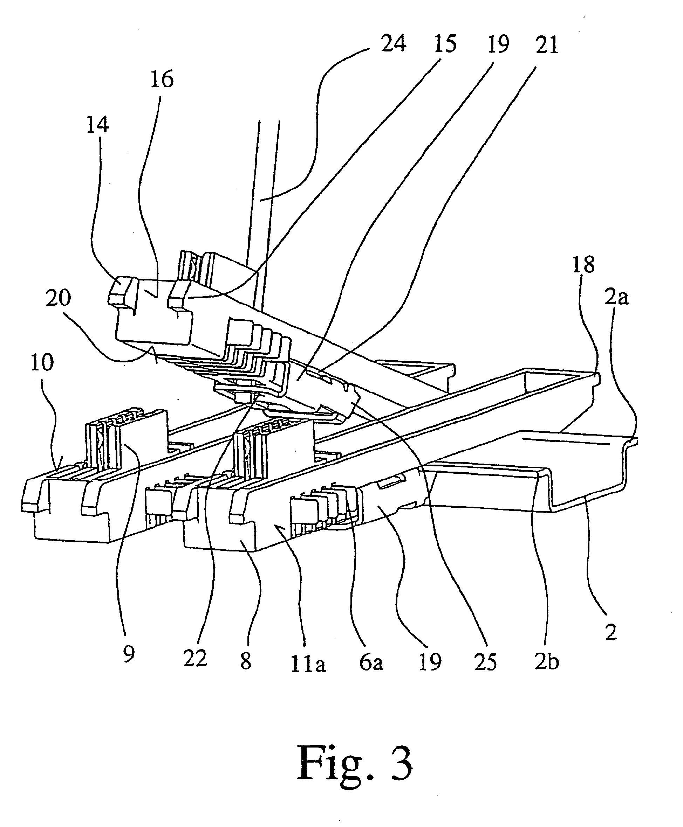

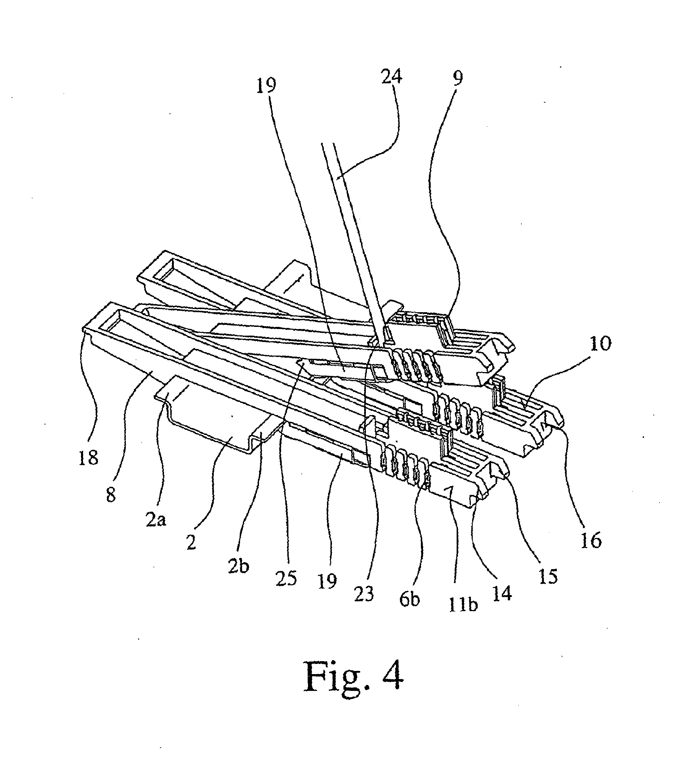

Der Riegel 19 ist an sich an der Unterseite 20 des Sockelteils 8 angeordnet. Die Form des Riegels 19 ist etwa U-förmig, wobei sich der Riegel 19 über die gesamte Unterseite 20 des Sockelteils 8 erstreckt. Die oberen Enden der U-Schenkel sind aufeinander zu abgewinkelt und greifen jeweils in einen korrespondierenden Schlitz 21 an den Seiten 11a, 11b am Sockelteil 8 ein. Hierdurch ist der Riegel 21 unverlierbar am Sokkelteil 8 gehalten. Am Riegel 19 befindet sich eine Betätigungsöffnung 22, während im Sockelteil 8 eine durchgehende, von der Oberseite 10 her zugängliche Einführöffnung 23 für ein Werkzeug 24, wie einen Schraubendreher, vorgesehen ist (vgl. insbesondere Fig. 3 und 4). Die Einführöffnung 23 ist dabei nur zugänglich, wenn das Oberteil 7 vom Sockelteil 8 abgenommen worden ist. Im Verriegelungszustand, in dem der Riegel 19 mit seinem Verriegelungsabschnitt 25 den Vorsprung 2b der Tragschiene 2 untergreift, sind die Betätigungsöffnung 22 und die Einführöffnung 23 versetzt zueinander angeordnet, wobei ein Einführen des Werkzeugs 24 in die Betätigungsöffnung 22 aber noch möglich ist. Durch ein weiteres Einführen des Werkzeugs 24 öffnet sich die Betätigungsöffnung 22 in die Einführöffnung 23, wobei der Riegel 19 entgegen der Federbelastung bewegt wird, bis der Verriegelungsabschnitt 25 den entsprechenden Vorsprung 2b der Tragschiene 2 nicht mehr untergreift und das Sockelteil 8 damit von der Tragschiene 2 abgeschwenkt werden kann.

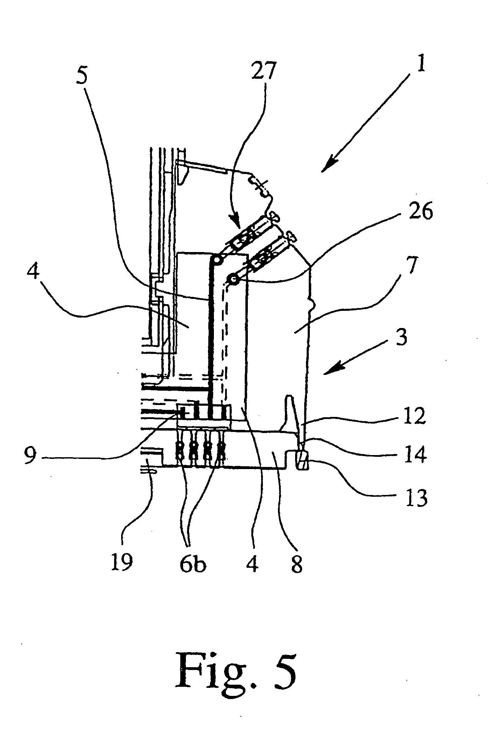

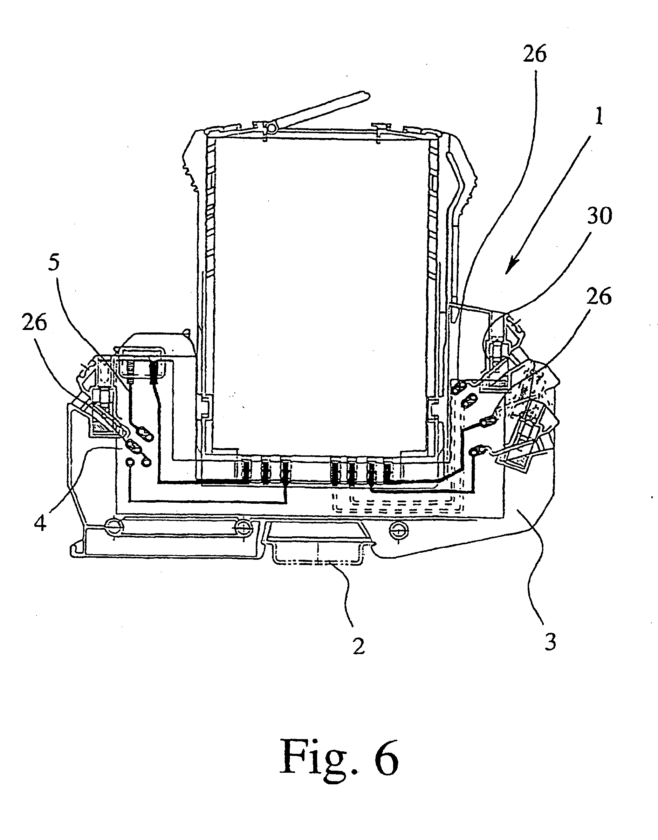

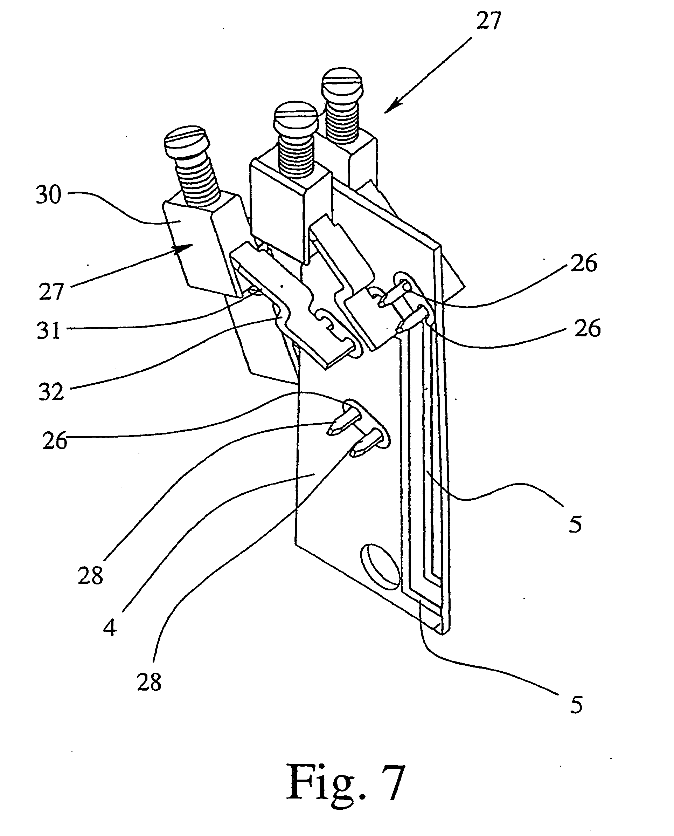

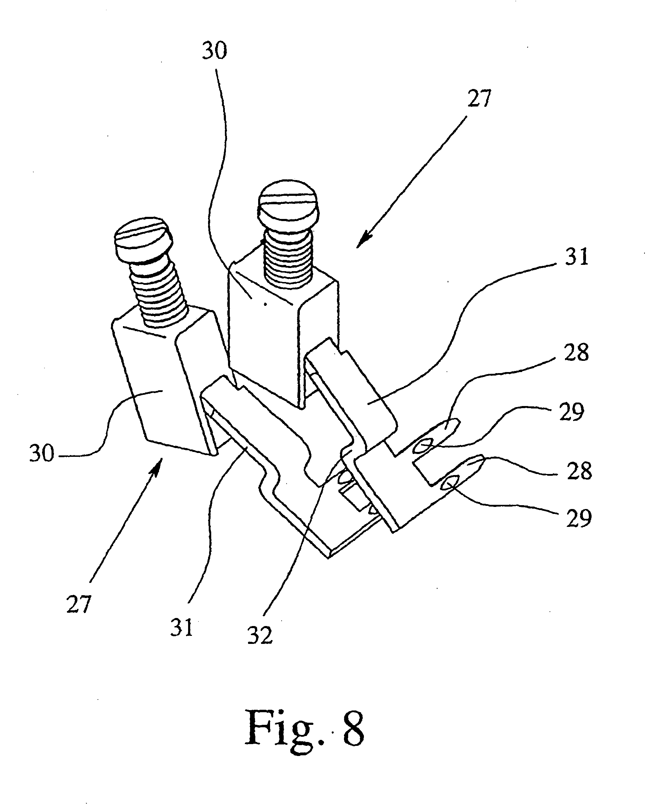

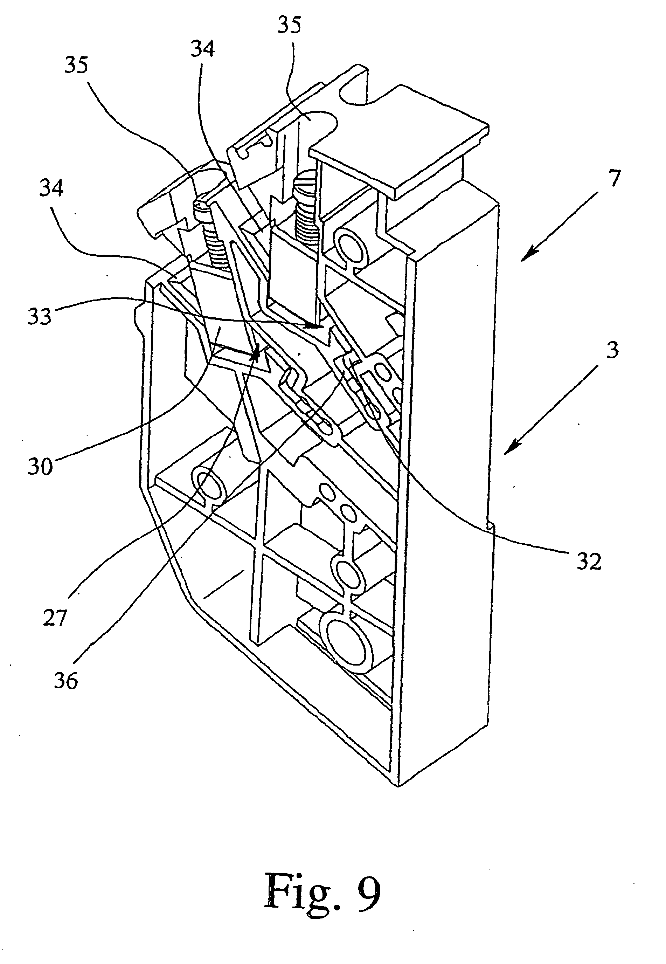

Die Leiterplatte 4 selbst ist im Gehäuse 3 bzw. im Oberteil 7 des Gehäuses 3 in einer Führung gehalten, die auch das Einschieben der Leiterplatte 4 beim Einbau erleichtert. Wie sich insbesondere aus den Fig. 5 bis 9 ergibt, sind in der Leiterplatte 4 und im Oberteil 7 jeweils korrespondierende Öffnungen 26 vorgesehen, die zum Einstekken wenigstens einer Fixiereinrichtung 27 von der Außenseite des Gehäuses 3 her dienen. Obwohl die Verwendung von Fixiereinrichtungen 27 natürlich besonders vorteilhaft in Verbindung mit den zweiteiligen Gehäusen 3 der erfindungsgemäßen Art ist, können die Fixiereinrichtungen 27 auch zum Fixieren der Leiterplatte 4 in einem einteiligen Gehäuse 3 vorgesehen sein, wie dies in Fig. 6 dargestellt ist. Die Verbindung der einzelnen Fixiereinrichtungen 27 mit der Leiterplatte 4 erfolgt lediglich über das Einstecken, ohne daß eine weitere Verbindung, insbesondere eine Verlötung erforderlich ist.

Zum Einstecken weist die Fixiereinrichtung 27 bei der in Fig. 5 dargestellten Ausführungsform einen Einsteckschenkel 28 auf, während bei den in den Fig. 6 bis 9 dargestellten Ausführungsformen jeweils zwei Einsteckschenkel 28 pro Fixiereinrichtung 27 vorgesehen sind. Die Einsteckschenkel 28 verlaufen etwa rechtwinklig zur Ebene der Leiterplatte 4 und damit koaxial zur Tragschienenrichtung R. Da die einzelnen Einsteckschenkel 28 lediglich in die Leiterplatte 4 eingesteckt sind, ist zur Verbesserung der Steckverbindung wenigstens eine Verdickung 29 am Einsteckschenkel 28 vorgesehen.

Neben ihrer Fixierungsfunktion dienen die einzelnen Fixiereinrichtungen 27 vorliegend aber auch zum Anschluß von Zuführungskontakten. Zu diesem Zweck ist am dem Einsteckschenkel 28 gegenüberliegenden Ende der Fixiereinrichtung 27 ein Klemmenelement 30 vorgesehen. Bei dem in den Fig. 6 bis 9 dargestellten Klemmenelement 30 handelt es sich vorliegend um eine Schraubklemme. Die Öffnungen 27 befinden sich jeweils im Bereich von Leiterbahnen 5, so daß sich beim Einstecken eines Einsteckschenkels 28 eine Kontaktierung mit der betreffenden Leiterbahn 5 ergibt.

Der im Klemmenelement 30 vorhandene Kontaktschenkel ist aus dem Klemmenelement 30 als Schenkel 31 herausgeführt. Von dem Schenkel 31 etwa im rechten Winkel abgewinkelt sind die Einsteckschenkel 28. Vor der Abwinkelung der Einsteckschenkel 28 ist am Schenkel 31 eine Stufe 32 ausgebildet.

Die Fixiereinrichtungen 27 sind jeweils in korrespondierenden Aufnahmen 33 im Gehäuse 3 bzw. im Oberteil 7 des Gehäuses 3 aufgenommen. Zum Anschluß von Zuführungskontakten ist dabei für jede Fixiereinrichtung 27 eine Anschlußöffnung und zur Betätigung des Klemmelements 30 jeweils eine Betätigungsöffnung 35 vorgesehen. Korrespondierend zur Stufe 32 am Schenkel 31 ist im übrigen in der Aufnahme 33 ein korrespondierender stufenförmiger Schlitz 36 vorgesehen, in dem die Stufe 32 am Gehäuse 3 anliegt, so daß etwaige Druck- und Zugbelastungen auf das Gehäuse 3 übertragen werden.

Um die Aufnahme 33 verschließen zu können, weist das Gehäuse 3 bzw. das Oberteil 7 eine Abdeckung 37 auf, die lösbar mit dem Gehäuse 3 bzw. dem Oberteil 7 verbunden, insbesondere mit diesem verrastet werden kann.

## Patentansprüche

1. Elektrisches oder elektronisches Gerät (1) zum Aufsetzen auf eine Tragschiene (2), mit einem Gehäuse (3), mit wenigstens einer im Gehäuse (3) angeordneten Leiterplatte (4) und mit in Längsrichtung (R) der Tragschiene (2) weisenden Kontakten (6a, 6b) für eine Daten- und/oder Energiebusverbindung mit benachbarten, auf die Tragschiene (2) aufgesetzten und korrespondierende Kontakte aufweisenden Elektronikgeräten,
**dadurch gekennzeichnet,**
**daß** das Gehäuse (3) mindestens zweiteilig ausgebildet ist und ein die Leiterplatte (4) aufnehmendes Oberteil (7) und ein die Kontakte (6a, 6b) aufweisendes Sockelteil (8) vorgesehen sind,
**daß** das Oberteil (7) mit dem Sockelteil (8) über eine erste Verriegelung und das Sokkelteil (8) mit der Tragschiene (2) über eine zweite Verriegelung lösbar verbindbar sind,
**daß** die zweite Verriegelung einen federbelasteten, am Sockelteil (8) verschiebbar gehaltenen Riegel (19) zum einseitigen Verriegeln der Tragschiene (2) aufweist,
**daß** der Riegel (19) im Bereich der Unterseite (20) des Sockelteil (8) vorgesehen ist,
**daß** am Riegel (19) eine Betätigungsöffnung (22) und auf der Oberseite (10) des Sokkelteils (8) eine von der Oberseite (10) des Sockelteils (8) her zugängliche durchgehende Einführöffnung (23) für ein Werkzeug vorgesehen sind, wobei die Einführöffnung (23) nur bei abgenommenem Oberteil (7) zugänglich ist,
so daß die zweite Verriegelung erst nach dem Entriegeln der ersten Verriegelung und nur nach der Abnahme des Oberteils (7) vom Sockelteil (8) entriegelbar ist,
**daß** die Betätigungsöffnung (22) im verriegelten Zustand des Sockelteils (8) derart versetzt zur Einführöffnung (23) angeordnet ist, daß sich die Betätigungsöffnung (22) beim Einführen des Werkzeugs (24) vergrößert, der Riegel (19) entgegen der Federbelastung verschoben und das Sockelteil (8) freigegeben wird, und
**daß** das Sockelteil (8) auf die Tragschiene (2) aufschwenkbar ist.

2. Elektrisches oder elektronisches Gerät nach Anspruch 1, **dadurch gekennzeichnet, daß** die erste Verriegelung und/oder die zweite Verriegelung als Rastverbindung ausgebildet sind.

3. Elektrisches oder elektronisches Gerät nach Anspruch 2, **dadurch gekennzeichnet, daß** die erste Verriegelung wenigstens einen federnden Rastarm (12) und zum Rastarm (12) korrespondierende Rasthaken (14, 15) aufweist und vorzugsweise der Rastarm (12) am Oberteil (7) und die Rasthaken (14, 15) am Sockelteil (8) vorgesehen sind.

4. Elektrisches oder elektronisches Gerät nach einem der Ansprüche 1 bis 3, **dadurch gekennzeichnet, daß** das Oberteil (7) auf das Sockelteil (8) aufschwenkbar ist und vorzugsweise die erste Verriegelung einen von der Außenseite des Gehäuses (3) manuell betätigbaren Griff- oder Eingriffsabschnitt am Rastarm (12) zum Lösen des Oberteils (7) vom Sockelteil (8) aufweist.

5. Elektrisches oder elektronisches Gerät nach einem der Ansprüche 1 bis 4, **dadurch gekennzeichnet, daß** in der Leiterplatte (4) und im Oberteil (7) jeweils korrespondierende Öffnungen (26) zum Einstecken wenigstens einer Fixiereinrichtung (27) von der Außenseite des Gehäuses (3) vorgesehen sind und vorzugsweise die Fixiereinrichtung (27) zur Verbindung mit der Leiterplatte (4) lediglich in diese eingesteckt ist, ohne weiter mit der Leiterplatte (4) verbunden zu sein.

6. Elektrisches oder elektronisches Gerät nach Anspruch 5, **dadurch gekennzeichnet, daß** die Fixiereinrichtung (27) wenigstens einen, vorzugsweise zwei in Längsrichtung (R) der Tragschiene (2) ausgerichtete Einsteckschenkel (28) aufweist und vorzugsweise am Einsteckschenkel (28) wenigstens eine Verdickung (29) vorgesehen ist.

7. Elektrisches oder elektronisches Gerät nach Anspruch 5 oder 6, **dadurch gekennzeichnet, daß** die Fixiereinrichtung (27) zum elektrischen Anschluß vorgesehen ist, vorzugsweise die Fixiereinrichtung (27) wenigstens ein Klemmenelement (30) aufweist und der Einsteckschenkel (28) mit wenigstens einer Leiterbahn (5) der Leiterplatte (4) kontaktiert.

8. Elektrisches oder elektronisches Gerät nach einem der Ansprüche 5 bis 7, **dadurch gekennzeichnet, daß** die Fixiereinrichtung (27) in einer korrespondierenden Aufnahme (33) im Oberteil (7) aufgenommen ist und vorzugsweise im Oberteil (7) wenigstens eine Anschlußöffnung (34) und wenigstens eine Betätigungsöffnung (35) zum Klemmenelement (30) vorgesehen sind.

9. Elektrisches oder elektronisches Gerät nach Anspruch 7 oder 8, **dadurch gekennzeichnet, daß** die Fixiereinrichtung (27) einen aus dem Klemmenelement (30) herausragenden Schenkel (31) aufweist, von dem der Einsteckschenkel (28) absteht und am Schenkel (31) eine Stufe (32) und in der Aufnahme (33) ein korrespondierender stufenförmiger Schlitz (36) vorgesehen sind, in dem die Stufe (32) angeordnet ist und am Gehäuse (3) anliegt.

10. Elektrisches oder elektronisches Gerät nach Anspruch 8 oder 9, **dadurch gekennzeichnet, daß** eine Abdeckung (37) für die Aufnahme (33) vorgesehen ist und vorzugsweise die Abdeckung (37) lösbar mit dem Gehäuse (3) verbindbar, insbesondere verrastbar ist.

## Claims

1. Electrical or electronic device (1) for placement on a support rail (2), with a housing (3), with at least one circuit board (4) located in the housing (3), and with contacts (6a, 6b) which point in the lengthwise direction (R) of the support rail for a data and/or power bus connection to adjacent electronic devices have the corresponding contacts and which are placed on the support rail (2),
**characterized in**
**that** the housing (3) is formed of at least two parts and a top part (7) housing the circuit board (4) and a base part (8) having contacts (6a, 6b) are provided,
**that** the top part (7) is detachably attached to the base part (8) using a first locking device and the base part (8) is detachably attached to the support rail (2) using a second locking device
**that** the second locking device has a spring-loaded latch (19) which is held to slide on the base part (8) for unilateral locking to the support rail (2),
**that** the latch (19) is located in the area of the bottom (20) of the base part (8),
**that** on the latch (19) there is an actuation opening (22) and on the top side (10) of the base part (8) there is a continuous insertion opening (23), accessible from the top (10) of the base part (8), for a tool (24), wherein the insertion opening (23) is only accessible when the top part (7) is removed,
so that the second locking device can only be released after releasing the first locking device and removing the top part (7) from the base part (8),
**that** the actuation opening (22) in the locked state of the base part (8) is arranged offset to the insertion opening (22) such that when the tool (24) is inserted the actuation opening becomes larger, the latch (19) is moved against the spring load and the base part (8) is released, and
**that** the base part (8) can be swivelled onto the support rail (2).

2. Electrical or electronic device according to claim 1, **characterized in that** the first locking device and/or the second locking device is/are formed as catch connections.

3. Electrical or electronic device according to claim 2, **characterized in that** the first locking device has at least one spring-loaded catch arm (12) and catch hooks (14, 15) which correspond to the catch arm (12), and wherein preferably there is a catch arm (12) on the top part (7) and there are catch hooks (14, 15) on the base part (8).

4. Electrical or electronic device according to any one of claims 1 to 3, **characterized in that** the top part (7) can be swivelled onto the base part (8), and wherein preferably the first locking device has a handle or engagement section which can be manually activated from the outside of the housing (3) on the catch arm (12) for detachment of the top part (7) from the base part (8).

5. Electrical or electronic device according to any one of claims 1 to 4, **characterized in that** the circuit board (4) and in the top part (7) there are the corresponding openings (26) for insertion of at least one fixing means (27) from the outside of the housing (3) and wherein preferably the fixing means (27) for connection to the circuit board (4) is simply inserted into the latter without being further connected to the circuit board (4)

6. Electrical or electronic device according to claim 5, **characterized in that** the fixing means (27) has at least one, preferably two insertion legs (28) aligned in the lengthwise direction (R) of the support rail, and wherein preferably on the insertion leg (28) there is at least one thickened area (29).

7. Electrical or electronic device according to claim 5 or 6, **characterized in that** there is a fixing means (27) for electrical connection, wherein preferably the fixing means (27) has at least one terminal element (30), and wherein the insertion leg (28) makes contact with at least one printed conductor (5) of the circuit board (4).

8. Electrical or electronic device according to any one of claims 5 to 7, **characterized in that** the fixing means (27) is held in a corresponding receiver (33) in the top part (7) and wherein preferably in the top part (7) there is at least one connection opening (34) and there is at least one actuation opening (35) for the terminal element (30).

9. Electrical or electronic device according to claim 7 or 8, **characterized in that** the fixing means (27) has a leg (31) which projects out of the terminal element (30) and from which the insertion leg (28) projects, and wherein on the leg (31) there is a step (32) and in the receiver (33) there is a corresponding step-shaped slot (36) in which the step (32) is located and adjoins the housing (3).

10. Electrical or electronic device according to claim 8 or 9, **characterized in that** there is a cover (37) for the receiver (33) and wherein preferably the cover (37) can be detachably joined to the housing (3), especially can catch.

## Revendications

1. Appareil (1) électrique au électronique destiné à être posé sur un rail support (2), comprenant un boîtier (3), avec au moins un circuit imprimé (4) disposé dans le boîtier (3) et des contacteurs (6a, 6b) orientés dans le sens longitudinal (R) du rail support (2) pour une connexion par bus de données et/ou d'énergie avec des appareils électrique au électronique voisins, posés sur le rail support (2) et présentant des contacteurs correspondants,
**caractérisé en ce que**
le boîtier (3) est conformé en au moins deux parties, une partie supérieure (7) recevant le circuit imprimé (4) ainsi qu'une partie formant embase (8) présentant les contacteurs (6a, 6b) étant prévues,
**en ce que** la partie supérieure (7) est susceptible d'être reliée avec la partie formant embase (8) par l'intermédiaire d'un premier verrouillage et la partie formant embase (8) est susceptible d'être reliée de façon amovible avec le rail support (2) par l'intermédiaire d'un second verrouillage,
**en ce que** le second verrouillage présente un verrou (19) soumis à une contrainte d'élasticité, maintenu en position coulissant le long de la partie formant embase (8) pour verrouiller d'un côté le rail support (2), et **en ce que** le verrou (19) est prévu dans la zone de la face inférieure (20) de la partie formant embase (8),
**en ce que** sont prévues sur le verrou (19) une ouverture d'actionnement (22) et sur la face supérieure (10) de la partie formant embase (8) une ouverture traversante d'introduction (23) pour un outil (24), accessible à partir de la face supérieure (10) de la partie ferment embase (8), et **en ce que** l'ouverture d'introduction (23) n'est accessible que dans le cas ou la partie supérieure (7) est enlevée, de telle sorte que le second verrouillage est susceptible d'être déverrouillé seulement après le déverrouillage du premier verrouillage et seulement après avoir enlevé ou séparé la partie supérieure (7) de la partie formant embase (8),
**en ce que** l'ouverture d'actionnement (22) est, dans l'état verrouillé de la partie formant embase (8), en position décalée par rapport à l'ouverture d'introduction (23), de telle sorte que l'ouverture d'actionnement (22) s'agrandit lors de l'introduction de l'outil (24), que le verrou (19) se déplace de manière antagoniste à la contrainte élastique et que la partie formant embase (8) soit débloquée,
et **en ce que** la partie ferment embase (8) est rabattable sur le rail support (2).

2. Appareil électrique ou électronique selon la revendication 1, **caractérisé en ce que** le premier et/ou le second verrouillage sont réalisés sous forme de liaison de blocage.

3. Appareil électrique ou électrique selon la revendication 2, **caractérisé en ce que** le premier verrouillage présente une patte de blocage (12) élastique et des crochets de blocage (14, 15) en correspondance avec la patte de blocage (12), et **en ce que** de préférence sont prévus respectivement la patte de blocage (12) sur la partie supérieur (7) et les crochets de blocage (14, 15) sur la partie formant embase (8).

4. Appareil électrique ou électronique selon l'une des revendications 1 à 3, **caractérisé en ce que** la partie supérieure (7) est rabattable sur la partie formant embase (8), et **en ce que** de préférence le premier verrouillage présente, sur la patte de blocages (12) une section de prise ou de mise en prise à manoeuvrer manuellement à partir de l'extérieur du boîtier (3), pour le déblocage de la partie supérieur (7) par rapport a la partie formant embase (8).

5. Appareil électrique ou électronique selon l'une des revendications 1 à 4, **caractérisé en ce que** dans le circuit imprimé (4) et dans la partie supérieure (7), des ouvertures (26) correspondantes sont chaque fois prévues pour insérer au moins un dispositif de fixation (27) à partir de la face externe du boîtier (3) et **en ce que** de préférence le dispositif de fixation (27) pour la liaison avec le circuit imprimé (4) est uniquement inséré dans le circuit imprimé, sans autre liaison avec le circuit imprimé (4).

6. Appareil électrique ou électronique selon la revendication 5, **caractérisé en ce que** le dispositif de fixation (27) présente au moins une, et de préférence deux, branches ou pattes d'insertion (28) orientées dans le sens longitudinal (R) du rail support (2), et **en ce que** de préférence sur la ou les branches d'insertion (28) un renfort ou surépaisseur (29) est prévu.

7. Appareil électrique ou électronique selon la revendication 5 ou 6, **caractérisé en ce que**l dispositif de fixation (27) est prévu pour le raccordement électrique, de préférence en présentant au moins un élément formant borne de connexion (30) et en ce que les branche d'insertion (28) vient en contact avec une piste conductrice (5) du circuit imprimé (4)

8. Appareil électrique ou électronique salon l'une des revendications 5 à 7, **caractérisé en ce que** le dispositif de fixation (27) est logé dans un logement (33) correspondant dans la partie supérieure (7) et **en ce que** de préférence dans la partie supérieure (7) sont prévues au moins une ouverture de raccordement (34), ainsi qu'au moins une ouverture d'actionnement (35) pour la borne de connexion (30).

9. Appareil électrique ou électronique selon la revendication 7 ou 8, **caractérisé en ce que** le dispositif de fixation (27) présente une branche ou patte (31) faisant saillie à partir de la borne de connexion (30), une branche d'insertion (28) étant éloignée de ladite branche ou patte, et **en ce que** sont respectivement prévus sur la branche (31) un épaulement (32) et dans le logement (33) une rainure ou fente (36) correspondante à profil étagé, dans laquelle l'épaulement (32) est disposé et repose sur le boîtier (3).

10. Appareil électrique ou électronique salon la revendication 8 ou 9, **caractérisé en ce qu'**il est prévu pour le logement (33) un élément de recouvrement (37), qui est de préférence susceptible d'être relié de manière amovible au boîtier (3) et en particulier susceptible d'être bloqué.
